# EUROPEAN PATENT APPLICATION

(11) **EP 0 763 853 A1**
(43) Date of publication of application: **19.03.1997**
(21) Application number: 95114649.7
(22) Date of filing: 18.09.1995
(51) Int. Cl.: H01L 23/485

(54) **Improvements in or relating to integrated circuits**

(71) Applicant: TEXAS INSTRUMENTS INCORPORATED, Dallas, Texas 75243 (US); TEXAS INSTRUMENTS ITALIA S.p.A., 67051 Avezzano (AQ) (IT)
(72) Inventor: Cacioppo, Onofrio Antonino, I-67051 Avezzano (Aq) (IT)
(74) Representative: Brown, Angela Mary

(57) **Abstract**

The invention concerns a process for the realisation of connection bumps (13) on integrated circuits or chips which provides for a selective deposition of a Sn/Zn welding alloy onto the pads (12) of the chip (11), without that chip (11) being subjected to any surface treatment. The Sn/Zn based alloy has the feature that it is welded directly onto the aluminium pads of the chip.

## Description

The present invention relates to a process for producing connection bumps on integrated circuits.

More particularly, the invention concerns a process that allows a modification of the requirements for the connection of bumps on integrated circuits.

An integrated circuit is an electronic circuit made using micro electronic techniques, starting from a Wafer upon which tens of single integrated circuits (chips) are produced. Each chip is typically of rectangular shape having sides several millimetres long.

Every chip has a plurality of terminations made up of a plurality of pads on the surface.

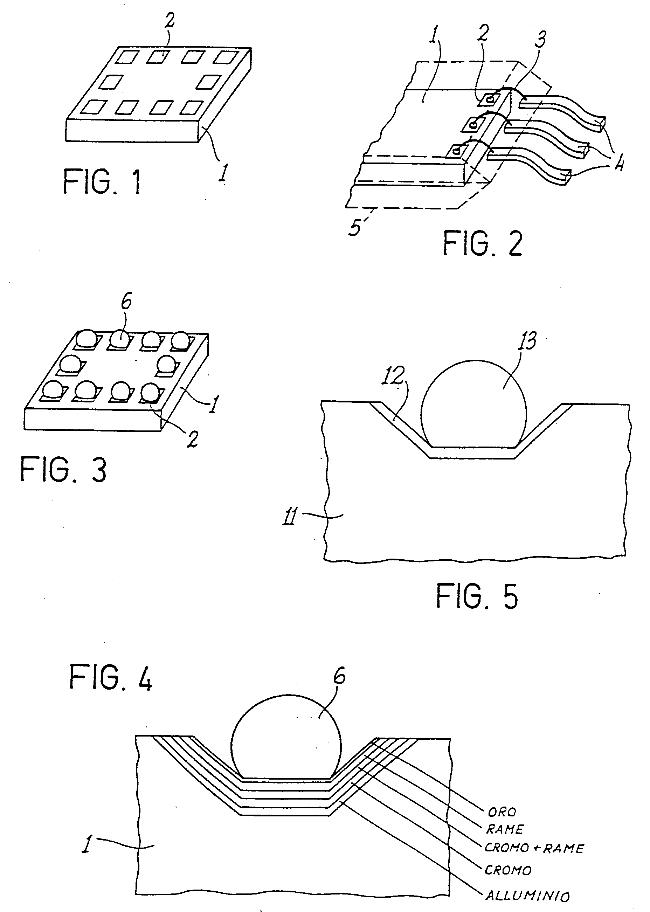

An illustration of this is shown in figure 1, wherein said pads are indicated by the reference number 2, while the chip is indicated by the reference number 1.

As illustrated in figure 2, in order to improve the handling of the chip and to facilitate its connection, the chip 1 is connected, by gold wires 3 to a metallic frame 4.

The assembly is encased within a plastic body 5 from which pins 4 project. Each one of said pins corresponding to a pad 2 on the chip 1 , so that a final product weldable on the printed circuit (not shown) is obtained.

At present, the integrated circuits including a plastic body 5 and pins 4 are typically used.

In order to minimise the dimensions of the integrated circuit and to make the electric connections more direct a new technology has been developed.

In this case metallic alloy bumps 6 are provided on the welding pads 2 as can be seen from the enclosed figure 3.

Since the pads 2 comprise aluminium provided on the end layer it is necessary to perform surface treatments on the chip in order to allow both the adhesion of the alloys usually employed and the following multiple meltings.

These surface treatments comprise selective evaporation of different materials, by a proper masking of the Wafer. In this way the aluminium pads have been replaced by gold pads upon which it is possible to produce the bumps 6.

In figure 4 is shown the section of the bump 2 with the different layers deposited for the transition from the aluminium to the gold.

The bump 6 is typically made up of a Sn/Pb alloy. The other layers are aluminium, chrome, an alloy of chrome and copper, copper and gold.

As demonstrated, the technique presently used to realise the bump requires a complicated and laborious routine in which the chips undergo a complicated surface treatment.

After having prepared the surface of the chip, the growth of the bumps occurs. This operation is carried out by placing metallic or photolithographic masks on the chip, leaving opened only the area corresponding to the welding pads.

Afterwards, by a vacuum evaporation process, a certain amount of welding alloy is deposited. When the alloy has melted again this causes the bumps to take their normal spherical shape.

According to one aspect of the present invention there is provided a process for forming a connection bump on an integrated circuit or chip comprising forming the bump of a Sn/Zn alloy, on the pads of the circuit without carrying out any surface treatment of the integrated circuit.

A main object of the present invention is that of improving the process of the prior art for providing connection bumps on integrated circuits by modifying both the surface preparation step and the following phase of growth of the bumps.

Particularly, the solution according to the invention drastically reduces the processes that would otherwise be necessary with the conventional process.

Furthermore, the solution according to the present invention still allows direct use of the chip provided by the Wafer manufacturer in view of the fact that does not provide a surface treatment.

Another advantage of the process according to the invention is that it allows the use of so called 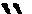 pasty*"* bumps, which process utilises the currently existing assembling technologies so that it is not necessary to undergo further investments in new processing steps.

Thus, the solution according to the invention avoids the use of an alloy containing lead, and allows utilisation of "ecological" alloys that are now more widespread.

These and other results are obtained according to the invention in which bumps are produced by the selective deposition of a alloy Sn/Zn, or another Sn/Zn based alloy, thereby direct welding to the aluminium on the chip or directly onto the welding pads of the chip is achieved.

According to a particularly preferred embodiment of the invention, the welding alloy is a Sn/Zn alloy having the eutectic composition Sn₉₁/Zn₉.

Still according to the invention, the bumps can be realised using a selective deposition with a metallic mask for silk-screen printing.

Also preferably the deposition is carried out by a sputtering technique.

According to the invention, the bumps can be realised by a selective deposition with metallic or photolithographic masking and direct evaporation of the alloy without any further intermediate treatment of the surface of the chip.

Furthermore, according to the invention, the welding alloy can be placed on the wafer or on the printed circuit as a silk-screen printing paste.

The welding alloy can also be placed on the chip as a filing mixed with a suitable flowing medium.

The present invention will be now described for illustrative but not limitative purposes according to a preferred embodiment, with particular reference to the figure 5 of the enclosed drawings, which shows a section of a chip realised by the inventive process.

Referring to figure 5, and comparing it with figures 3 and 4 already described it can be noted that above the chip 11 aluminium pads 12 are provided.

In the solution according to the invention, on the aluminium pad a Sn/Zn alloy bump 13 is grown. Ideally the Sn/ZN alloy has a particular eutectic composition for example Sn₉₁/Zn₉.

The above alloy is directly welded on the untreated surface of the pad 12, thereby allowing use of the chip as proposed.

As already said, the bumps 13 are realised by a selective deposition of microspheres on the welding pads 12, employing known technologies, for example sputtering, Chemical Vapour Deposition (CVD), Photolithographic techniques etc.

The process can further be carried out by silk-screen printing Sn/Zn alloy filings mixed with a proper flowing medium on chips 11 which have not been subjected to any surface treatment.

The following re-melting of the weld paste has allowed the production of bumps having a well defined spherical shape.

Tests relevant to mechanical stresses carried out on the test sample have shown that the bumps have the necessary mechanical resistance.

The present invention has been described for illustrative, but not limitative, purposes according to its preferred embodiments, but it is to be understood that changes and/or modifications can be introduced by those skilled in the art without departing from the scope of the invention as defined by the enclosed claims.

## Claims

1. A process for forming a connection bump on an integrated circuit or chip comprising forming the bump of a Sn/Zn alloy, on the pads of the circuit without carrying out any surface treatment of the integrated circuit.

2. The process of Claim 1, wherein the step of forming the bump comprises selectively depositing the Sn/Zn alloy.

3. The process of Claim 1 or Claim 2, wherein said alloy is a Sn/Zn alloy having an eutectic composition of about Sn₉₁/Zn₉.

4. The process of any preceding claim, further comprising forming the bumps using a selective deposition with a mask for silk-screen printing.

5. The process of Claim 4, further comprising providing the mask as a metal mask.

6. The process of preceding Claims 4 or 5, wherein the alloy is placed on the circuit as silk-screen printing paste.

7. The process of any of Claims 1 - 3, further comprising forming the bumps by a selective deposition with a photolithographic masking to be realised by direct evaporation of the alloy.

8. The process of any of Claims 4 - 7, wherein the alloy is placed on the chip as filings mixed with a suitable flowing medium.

9. The process of any of preceding claims 1 to 3, further comprising forming the bumps by sputtering.

10. The process of any preceding claim, further comprising forming the pads of the chip from aluminium.

11. A bump for an integrated circuit the bump being formed of an Sn/Zn alloy.

12. The bump of claim 11, wherein the Sn/Zn alloy has an Eutectic composition of about Sn₉₁/Znₐ.

13. An integrated circuit having a connection bump thereon, the bump according to Claim 11 or Claim 12.
